# FASCICULE DE BREVET EUROPEEN

(11) **EP 3 361 268 B1**
(45) Date de publication et mention de la délivrance du brevet: **27.02.2019**
(21) Numéro de dépôt: 18150595.9
(22) Date de dépôt: 08.01.2018
(51) Int. Cl.: G01R 15/16, G01R 19/155, H01H 71/02

(54) **CIRCUIT DE SURVEILLANCE D'UN RÉSEAU D'ALIMENTATION ÉLECTRIQUE**
ÜBERWACHUNGSSCHALTUNG FÜR EIN STROMNETZES
MONITORING CIRCUIT OF AN ELECTRICAL POWER NETWORK

(30) Priorité: 13.02.2017 FR 1751145
(43) Date de publication de la demande: 15.08.2018
(73) Titulaire: Schneider Electric Industries SAS, 92500 Rueil-Malmaison (FR)
(72) Inventeur: HUIN, Bertrand, 69008 Lyon (FR); CAOUS, Philippe, 38460 Villemoirieu (FR)
(74) Mandataire: Dufresne, Thierry

(56) Documents cités:
- EP-A1- 1 906 190
- EP-A1- 2 538 229
- EP-A1- 3 001 206
- FR-A1- 2 984 514

## Description

### Domaine technique de l'invention

La présente invention concerne un circuit de surveillance d'un réseau d'alimentation électrique, ce genre de circuit étant habituellement placé sur la face avant d'un appareil électrique qui peut être du type interrupteur, disjoncteur, contacteur, sectionneur, interrupteur fusible ou recloser. L'invention est particulièrement adaptée pour surveiller les réseaux électriques de moyenne tension et haute tension, c'est-à-dire d'une tension supérieure à 1000V.

### Etat de la technique

Un tel circuit de surveillance comprend généralement un dispositif d'indication de présence tension (appelé aussi VPIS, c'est-à-dire Voltage Presence Indicator System) pour signaler la présence d'une tension circulant entre une phase et la terre sur chacune des phases du réseau d'alimentation électrique, ou un dispositif de détection de tension (appelé aussi VDS, c'est-à-dire Voltage Detector System) pour signaler l'absence de tension entre phase et terre sur chaque phase du réseau d'alimentation électrique.

Suivant les normes CEI61958 ou CEI61243-5, la finalité d'un dispositif VPIS ou d'un dispositif VDS, est d'informer les opérateurs de l'état de la tension du réseau d'alimentation électrique sur lequel le dispositif est installé. L'information «présence de tension» ou «absence de tension» se fait grâce à un voyant, généralement une diode électroluminescente à haute luminosité. Des dispositifs VPIS sont également utilisés par un comparateur de phases lorsqu'il faut vérifier la concordance de phases entre deux cellules électriques haute tension distinctes que l'on veut raccorder ensemble, ceci afin d'éviter de croiser les phases lors des raccordements. Un dispositif de type VPIS ou VDS mesure habituellement la tension phase-terre grâce à des capteurs capacitifs, de type capacité de bushing (ou capacité de traversée isolée).

Dans certaines applications, l'exploitant du réseau d'alimentation électrique souhaiterait pouvoir également installer d'autres dispositifs supplémentaires permettant notamment la détection de défaut. C'est le cas par exemple d'un dispositif appelé RGDAT (c'est-à-dire Rilevatore di Guasto Direzional e di Assenza Tensione) qui permet de détecter des défauts directionnels de la tension phase-terre et d'absence tension, et qui est défini suivant la Spécification ENEL DY1059 - Description Technique SD7865. Idéalement, ce type de dispositif supplémentaire devrait pouvoir être installé de façon temporaire, pour effectuer des campagnes de mesure ou pour diagnostiquer temporairement l'état du réseau électrique.

Le document EP1906190A1 décrit un circuit de protection ayant un dispositif de signalisation de tension et un dispositif de surveillance tension non amovibles. Le document EP2538229A1 décrit un dispositif pour comparaison de phases et le document EP3001206A1 décrit un dispositif d'estimation de tension.

Pour des raisons économiques et de facilité de mise en oeuvre, il serait intéressant qu'un tel dispositif supplémentaire utilise les mêmes raccordements et les mêmes capteurs de tension (capacité de bushing) que ceux utilisés par le dispositif de signalisation de tension existant dans le circuit de surveillance d'un appareil électrique.

Cependant, l'installation temporaire d'un second dispositif dans un circuit de surveillance comportant déjà un premier dispositif de signalisation de tension pose en particulier des problèmes d'adaptation d'impédance qui perturbent beaucoup les signaux de mesure reçus par ce circuit de surveillance et qui faussent donc les résultats, suivant que le second dispositif est présent ou non.

L'invention a donc pour but de régler ces problèmes de façon à ce qu'un circuit de surveillance puisse fonctionner aussi bien avec un seul dispositif de signalisation qu'avec deux dispositifs de signalisation et/ou de détection de défaut, en utilisant le même capteur de tension.

### Exposé de l'invention

Ce but est atteint par un circuit de surveillance d'un réseau d'alimentation électrique, le circuit comprenant deux bornes destinées à être connectées entre une phase du réseau et la terre, et comprenant, entre les deux bornes, un premier dispositif de signalisation de tension et un second dispositif de surveillance de tension. Le second dispositif est raccordé de façon amovible au circuit de surveillance, et le circuit de surveillance comporte :
- une impédance de compensation placée en parallèle du second dispositif,
- un moyen de connexion qui connecte l'impédance de compensation au circuit de surveillance lorsque le second dispositif est absent et qui déconnecte l'impédance de compensation lorsque le second dispositif est connecté au circuit de surveillance,
- une capacité de régulation de courant reliée en série avec l'impédance de compensation ou le second dispositif,
- une capacité de correction d'angle de phase reliée en série avec le premier dispositif, et
- une capacité de limitation de tension reliée entre les deux bornes du circuit de surveillance.

Selon une caractéristique, le premier dispositif est un dispositif de signalisation de présence de la tension phase-terre de type VPIS ou un dispositif de signalisation de l'absence de la tension phase-terre de type VDS . Selon une caractéristique, le second dispositif est un dispositif de détection de défaut directionnel de la tension phase-terre de type RGDAT.

Selon une autre caractéristique, la valeur de l'impédance de compensation est sensiblement égale à la valeur de l'impédance du second dispositif.

Selon une autre caractéristique, le moyen de connexion comporte une prise possédant un contact mobile qui est ouvert lors de l'insertion du second dispositif dans la prise de façon à déconnecter l'impédance de compensation du circuit de surveillance.

Selon une autre caractéristique, le circuit de surveillance comporte également un éclateur à gaz relié entre les deux bornes du circuit de surveillance.

L'invention concerne également un système de surveillance pour réseau d'alimentation électrique multiphases, le système comportant un tel circuit de surveillance, pour chaque phase du réseau d'alimentation.

### Description détaillée

D'autres caractéristiques vont apparaître dans la description détaillée qui suit faite en regard des dessins annexés dans lesquels :
- la figure 1 montre un schéma classique de raccordement d'un dispositif de signalisation de tension,
- les figures 2 et 3 montrent un schéma d'un exemple de circuit de surveillance selon l'invention, la figure 2 avec un dispositif complémentaire de détection et la figure 3 sans dispositif complémentaire de détection.

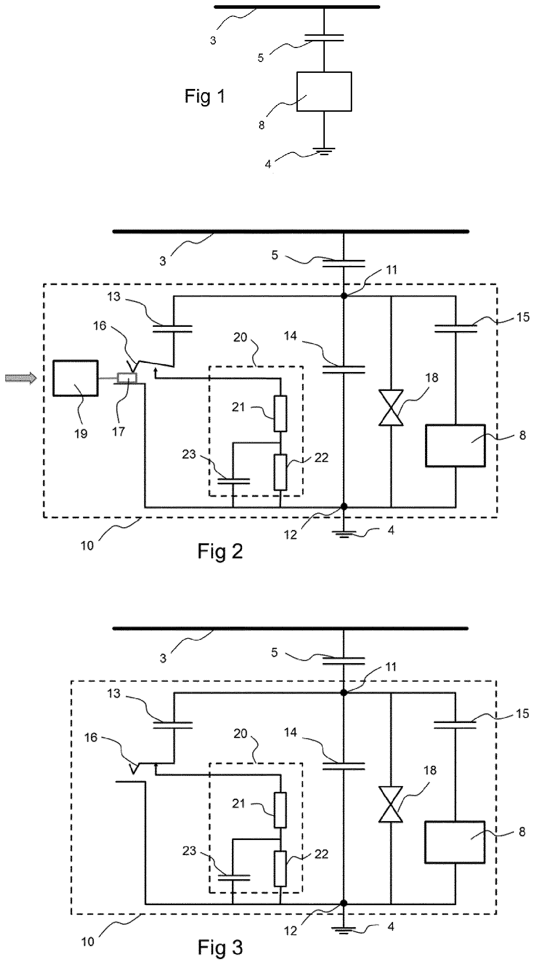

La figure 1 montre un schéma simplifié d'un circuit de surveillance bien connu qui comprend un dispositif de signalisation de tension 8, par exemple de type VPIS ou VDS. Un tel dispositif de signalisation est habituellement placé en face avant d'un appareil électrique et est relié entre une phase 3 d'un réseau d'alimentation électrique, via une capacité de bushing 5, et la terre 4. Cette capacité de bushing 5, dont la fonction initiale est l'isolation d'un conducteur de la phase 3, sert également de capteur de tension capacitif pour le dispositif de signalisation 8.

Un but de l'invention est de pouvoir utiliser ce même capteur de tension 5 pour un circuit de surveillance 10 qui comprendrait, outre le dispositif de signalisation de tension 8, un dispositif complémentaire 19 de détection pour la surveillance et la mesure de tension permettant notamment la détection de défaut directionnel de tension, tel qu'un dispositif de type RGDAT, ce dispositif complémentaire 19 étant connecté de façon non permanente.

Pour cela, la figure 2 montre le schéma d'un circuit de surveillance 10 conforme à l'invention. Le circuit de surveillance comporte deux bornes 11 et 12. La première borne 11 est connectée à un capteur de tension 5, qui est une capacité de bushing 5 de la phase 3, et la seconde borne 12 est connectée à la terre 4. Le circuit de surveillance 10 comprend un premier dispositif de signalisation de tension 8, identique à celui de la figure 1, un second dispositif de détection de défaut 19 et un moyen de connexion 16 permettant de connecter et déconnecter facilement le second dispositif 19. Les deux dispositifs 8 et 19 sont tous les deux raccordés entre les deux bornes 11 et 12, en parallèle via une capacité respective, donc ils utilisent avantageusement comme capteur de tension la même capacité de bushing 5.

Néanmoins, le fait de rajouter le second dispositif de détection 19 en parallèle du premier dispositif de signalisation 8 provoque évidemment un changement de l'impédance du circuit de surveillance 10 et en particulier diminue le courant circulant dans le premier dispositif 8, ce qui altère ses performances. La solution prévoit donc de rajouter une capacité 13 dite de régulation de courant qui est connectée en série avec le dispositif de détection 19, du côté de la première borne 11, ce qui a pour conséquence d'augmenter le courant circulant dans le premier dispositif de signalisation 8, de telle sorte que son fonctionnement soit satisfaisant.

Cependant, le fait de rajouter cette capacité de régulation 13 modifie de façon significative la phase angulaire du signal reçu par le dispositif de détection 19. De plus, le premier dispositif 8 dispose d'une limitation interne de tension dont la valeur minimale, qui est par exemple de l'ordre de 72 V, pourrait avoir un impact négatif sur la performance du second dispositif 19. La valeur de 72 V n'est donnée qu'à titre d'exemple et est liée au choix de l'éclateur interne du premier dispositif 8. Elle est par contre indépendante de la valeur de la haute tension et peut donc être utilisée pour des réseaux électriques haute tension de différents pays, car les niveaux varient d'un pays (tensions entre phases allant de 6kV à 36kV).

Pour y remédier, il est donc prévu d'une part de rajouter une capacité 14 dite de limitation connectée directement entre la première borne 11 et la seconde borne 12, et d'autre part de rajouter une capacité 15 dite de correction d'angle de phase connectée en série avec le premier dispositif 8, du côté de la première borne 11.

La capacité de limitation 14 a pour but de limiter la tension aux bornes du premier dispositif 8 pour un bon fonctionnement du second dispositif 19 et la capacité de correction d'angle de phase 15 a pour but de corriger l'angle de phase du signal reçu par le second dispositif 19. En effet, si le second dispositif 19 doit donner la direction d'un défaut détecté, il a besoin de connaître précisément l'angle de phase entre une tension représentative du réseau d'alimentation et un courant représentatif du réseau d'alimentation (typiquement la tension et le courant homopolaire).

Avec ses trois capacités rajoutées, le circuit de surveillance 10 est capable de faire fonctionner simultanément, sur le même capteur de tension 5, le premier dispositif de signalisation 8, par exemple de type VPIS, avec le second dispositif de détection 19, par exemple de type RGDAT.

Néanmoins, comme le second dispositif de détection 19 doit être raccordé au circuit de surveillance 10 de façon amovible, ce qui correspond à une utilisation temporaire seulement, sa déconnexion modifiera forcément l'impédance globale du circuit de surveillance 10 ce qui va perturber le fonctionnement du premier dispositif 8. L'invention prévoit donc d'ajouter une impédance de compensation 20 qui se substitue au second dispositif 19 lorsque celui-ci est absent et qui donc, comme le second dispositif 19, est connectée entre la capacité de régulation 13 et la seconde borne 12 reliée à la terre 4.

Pour pouvoir raccorder de façon exclusive soit le second dispositif 19, soit l'impédance de compensation 20, l'invention prévoit un moyen de connexion 16 qui connecte l'impédance de compensation 20 au circuit de surveillance 10 lorsque le second dispositif 19 est absent et qui déconnecte l'impédance de compensation 20 lorsque le second dispositif 19 est connecté au circuit de surveillance 10, de sorte que dans tous les cas l'impédance globale du circuit de surveillance reste sensiblement la même.

La figure 3 reprend l'exemple de la figure 2 dans lequel le second dispositif 19 est maintenant déconnecté et remplacé par l'impédance de compensation 20. De préférence, le moyen de connexion est une prise 16 qui possède un contact mobile et le second dispositif 19 comporte une prise complémentaire 17 complémentaire qui coopère avec la prise 16. Lors de sa connexion dans la prise 16, la prise complémentaire 17 du second dispositif 19 vient se connecter au contact mobile qui se déconnecte alors automatiquement de l'impédance de compensation 20. Inversement, lors du retrait de la prise complémentaire 17, le contact mobile reconnecte automatiquement l'impédance de compensation 20 au circuit de surveillance 10. Ainsi, le circuit de surveillance 10 est en permanence connecté soit au second dispositif 19, soit à l'impédance de compensation 20. Selon un mode de réalisation préféré, la prise 16 est une prise femelle de type jack qui coopère avec une prise mâle 17 complémentaire de type jack reliée au dispositif de second détection 19. Le contact interne de la prise femelle jack est raccordé à l'impédance de compensation 20 lorsque la prise mâle est déconnectée.

Selon un mode de réalisation préféré montré en figure 2, l'impédance de compensation 20 comprend une première résistance 21 en série avec une seconde résistance 22, ainsi qu'une capacité 23 reliée en parallèle avec la seconde résistance 22. La capacité 23 et la seconde résistance 22 ont une extrémité connectée à la terre 4 via la seconde borne 12. L'impédance de compensation 20 est calculée pour que sa valeur soit proche de celle du second dispositif de détection 19, de telle sorte que la présence ou l'absence du second dispositif 19 ne perturbe pas le fonctionnement du premier dispositif 8. Préférentiellement, la valeur de l'impédance de compensation 20 est sensiblement égale à la valeur de l'impédance du second dispositif de détection 19, c'est-à-dire avec un écart maximum de l'ordre de +/- 5%.

Par ailleurs, dans le schéma classique décrit en figure 1, le dispositif de signalisation 8 comporte un éclateur à gaz interne dont le rôle est de limiter les surtensions en cas de défaillance de la capacité de bushing 5, ce qui est une exigence normative. Typiquement, cette exigence normative impose de tenir la tension réseau sous 50A pendant 1 sec, puis, après 2-3 minutes, de tenir encore une fois la tension réseau sous 50A pendant 1 sec. Dans la cadre de l'invention, compte tenu de l'ajout de la capacité de limitation 14, cet éclateur à gaz interne pourra ne plus remplir sa fonction aussi bien. C'est pourquoi, l'invention prévoit un organe 18 pour limiter les surtensions, connecté entre les deux bornes 11 et 12 du circuit de surveillance 10. Préférentiellement, cet organe de limitation est un éclateur 18 à gaz.

Dans le cadre d'un réseau d'alimentation électrique multiphases, l'invention couvre également un système de surveillance qui comporte, pour chacune des phases du réseau, un circuit de surveillance 10 tel que décrit ci-dessus. Dans le cas d'un réseau triphasé, le second dispositif 19 pourrait ne comporter qu'un seul boîtier ayant trois prises complémentaires 17 se raccordant à chacun des circuit de surveillance 10 de chaque phase.

## Revendications

1. Circuit de surveillance (10) d'un réseau d'alimentation électrique, le circuit (10) comprenant deux bornes (11, 12) destinées à être connectées entre une phase (3) du réseau et la terre (4), et comprenant, entre les deux bornes (11, 12), un premier dispositif (8) de signalisation de tension et un second dispositif (19) de surveillance de tension, **caractérisé en ce que** le second dispositif (19) est raccordé de façon amovible au circuit de surveillance (10), et le circuit de surveillance comporte :
- une impédance de compensation (20) placée en parallèle du second dispositif (19),
- un moyen de connexion (16) qui connecte l'impédance de compensation (20) au circuit de surveillance (10) lorsque le second dispositif (19) est absent et qui déconnecte l'impédance de compensation (20) lorsque le second dispositif (19) est connecté au circuit de surveillance (10),
- une capacité de régulation (13) de courant reliée en série avec l'impédance de compensation (20) ou le second dispositif (19),
- une capacité de correction (15) d'angle de phase reliée en série avec le premier dispositif (8), et
- une capacité de limitation (14) de tension reliée entre les deux bornes (11, 12) du circuit de surveillance.

2. Circuit de surveillance selon la revendication 1, **caractérisé en ce que** le premier dispositif (8) est un dispositif de signalisation (VPIS) de présence de la tension phase-terre.

3. Circuit de surveillance selon la revendication 1, **caractérisé en ce que** le premier dispositif (8) est un dispositif de signalisation (VDS) de l'absence de la tension phase-terre.

4. Circuit de surveillance selon la revendication 1, **caractérisé en ce que** le second dispositif (19) est un dispositif de détection de défaut directionnel de la tension phase-terre (RGDAT).

5. Circuit de surveillance selon la revendication 1, **caractérisé en ce que** la valeur de l'impédance de compensation (20) est sensiblement égale à la valeur de l'impédance du second dispositif (19).

6. Circuit de surveillance selon la revendication 1, **caractérisé en ce que** le moyen de connexion comporte une prise (16) possédant un contact mobile qui est ouvert lors de l'insertion du second dispositif (19) dans la prise de façon à déconnecter l'impédance de compensation (20) du circuit de surveillance (10).

7. Circuit de surveillance selon la revendication 1, **caractérisé en ce qu'**il comporte également un éclateur à gaz (18) relié entre les deux bornes (11, 12) du circuit de surveillance.

8. Système de surveillance pour réseau d'alimentation électrique multiphases, **caractérisé en ce que** le système comporte, pour chaque phase (3) du réseau, un circuit de surveillance (10) selon l'une des revendications précédentes.

## Patentansprüche

1. Überwachungsschaltung (10) für ein Stromversorgungsnetz, wobei die Schaltung (10) zwei Klemmen (11, 12) umfasst, die dazu bestimmt sind, zwischen eine Phase (3) des Netzes und Erde (4) geschaltet zu werden, und zwischen den zwei Klemmen (11, 12) eine erste Vorrichtung (8) zur Spannungsanzeige und eine zweite Vorrichtung (19) zur Spannungsüberwachung umfasst, **dadurch gekennzeichnet, dass** die zweite Vorrichtung (19) lösbar an die Überwachungsschaltung (10) angeschlossen ist und die Überwachungsschaltung aufweist:
- eine Kompensationsimpedanz (20), die zu der zweiten Vorrichtung (19) parallelgeschaltet ist,
- ein Verbindungsmittel (16), welches die Kompensationsimpedanz (20) mit der Überwachungsschaltung (10) verbindet, wenn die zweite Vorrichtung (19) nicht vorhanden ist, und welches die Kompensationsimpedanz (20) trennt, wenn die zweite Vorrichtung (19) mit der Überwachungsschaltung (10) verbunden ist,
- eine Kapazität zur Stromregelung (13), die mit der Kompensationsimpedanz (20) oder der zweiten Vorrichtung (19) in Reihe geschaltet ist,
- eine Kapazität zur Phasenwinkelkorrektur (15), die mit der ersten Vorrichtung (8) in Reihe geschaltet ist,
- eine Kapazität zur Spannungsbegrenzung (14), die zwischen die zwei Klemmen (11, 12) der Überwachungsschaltung geschaltet ist.

2. Überwachungsschaltung nach Anspruch 1, **dadurch gekennzeichnet, dass** die erste Vorrichtung (8) eine Anzeigevorrichtung (VPIS) für das Vorhandensein der Phase-Erde-Spannung ist.

3. Überwachungsschaltung nach Anspruch 1, **dadurch gekennzeichnet, dass** die erste Vorrichtung (8) eine Anzeigevorrichtung (VDS) für das Nichtvorhandensein der Phase-Erde-Spannung ist.

4. Überwachungsschaltung nach Anspruch 1, **dadurch gekennzeichnet, dass** die zweite Vorrichtung (19) eine Vorrichtung zur richtungsselektiven Erkennung eines Fehlers der Phase-Erde-Spannung (RGDAT) ist.

5. Überwachungsschaltung nach Anspruch 1, **dadurch gekennzeichnet, dass** der Wert der Kompensationsimpedanz (20) im Wesentlichen gleich dem Wert der Impedanz der zweiten Vorrichtung (19) ist.

6. Überwachungsschaltung nach Anspruch 1, **dadurch gekennzeichnet, dass** das Verbindungsmittel einen Verbinder (16) aufweist, der einen beweglichen Kontakt besitzt, welcher beim Einsetzen der zweiten Vorrichtung (19) in den Verbinder geöffnet wird, so dass die Kompensationsimpedanz (20) von der Überwachungsschaltung (10) getrennt wird.

7. Überwachungsschaltung nach Anspruch 1, **dadurch gekennzeichnet, dass** sie außerdem einen Gasentladungsableiter (18) aufweist, der zwischen die Klemmen (11, 12) der Überwachungsschaltung geschaltet ist.

8. Überwachungssystem für ein mehrphasiges Stromversorgungsnetz, **dadurch gekennzeichnet, dass** das System für jede Phase (3) des Netzes eine Überwachungsschaltung (10) nach einem der vorhergehenden Ansprüche aufweist.

## Claims

1. Circuit (10) for monitoring an electrical power supply network, the circuit (10) comprising two terminals (11, 12) intended to be connected between a phase (3) of the network and the earth (4), and comprising, between the two terminals (11, 12), a first voltage signalling device (8) and a second voltage monitoring device (19), **characterized in that** the second device (19) is removably connected to the monitoring circuit (10), and the monitoring circuit comprises:
- a compensation impedance (20) placed in parallel to the second device (19),
- a connection means (16) which connects the compensation impedance (20) to the monitoring circuit (10) when the second device (19) is absent and which disconnects the compensation impedance (20) when the second device (19) is connected to the monitoring circuit (10),
- a current regulation capacitor (13) linked in series with the compensation impedance (20) or the second device (19),
- a phase angle correction capacitor (15) linked in series with the first device (8), and
- a voltage limiting capacitor (14) linked between the two terminals (11, 12) of the monitoring circuit.

2. Monitoring circuit according to Claim 1, **characterized in that** the first device (8) is a phase-earth voltage presence signalling device (VPIS).

3. Monitoring circuit according to Claim 1, **characterized in that** the first device (8) is a phase-earth voltage absence signalling device (VDS).

4. Monitoring circuit according to Claim 1, **characterized in that** the second device (19) is a phase-earth voltage directional fault detection device (RGDAT).

5. Monitoring circuit according to Claim 1, **characterized in that** the value of the compensation impedance (20) is substantially equal to the value of the impedance of the second device (19).

6. Monitoring circuit according to Claim 1, **characterized in that** the connection means comprises a socket (16) having a mobile contact which is open upon the insertion of the second device (19) into the socket so as to disconnect the compensation impedance (20) from the monitoring circuit (10).

7. Monitoring circuit according to Claim 1, **characterized in that** it also comprises a gas-filled spark gap (18) linked between the two terminals (11, 12) of the monitoring circuit.

8. Monitoring system for a multi-phase electrical power supply network, **characterized in that** the system comprises, for each phase (3) of the network, a monitoring circuit (10) according to one of the preceding claims.
